# EUROPÄISCHE PATENTSCHRIFT

(11) **EP 1 139 423 B1**
(45) Veröffentlichungstag und Bekanntmachung des Hinweises auf die Patenterteilung: **10.05.2006**
(21) Anmeldenummer: 01101997.3
(22) Anmeldetag: 29.01.2001
(51) Int. Cl.: H01L 23/525

(54) **Schmelzbrückenanordnung in integrierten Schaltungen**
Fuse structure for integrated circuits
Structure à fusible pour circuits intégrés

(30) Priorität: 11.02.2000 DE 10006243
(43) Veröffentlichungstag der Anmeldung: 04.10.2001
(73) Patentinhaber: Infineon Technologies AG, 81669 München (DE)
(72) Erfinder: Fischer, Helmut, 82024 Taufkirchen (DE); Müller, Jochen, 81825 München (DE)
(74) Vertreter: Müller - Hoffmann & Partner

(56) Entgegenhaltungen:
- DE-A- 19 817 749
- US-A- 5 532 966
- US-A- 5 835 425
- US-A- 5 905 295
- US-A- 5 986 321

## Beschreibung

Die Erfindung betrifft eine Schmelzbrückenanordnung in oder auf integrierten Schaltungen, insbesondere hochintegrierten Speicherchips, bei denen jeweils eine Bank von Schmelzbrücken zusammen mit einer mit den Schmelzbrücken elektrisch verbunden Auswertelogik, die feststellt, ob eine oder mehrere der Schmelzbrücken durchtrennt ist, neben und in Zuordnung zu einem Speicherfeldsegment angeordnet ist sowie eine Verwendung derselben in einem hochintegrierten Speicherchip

Aus den Druckschriften US-B-5 835 425, bzw. US-B-5 986 321 gehen bekannte Schmelzbrückenanordnungen hervor.

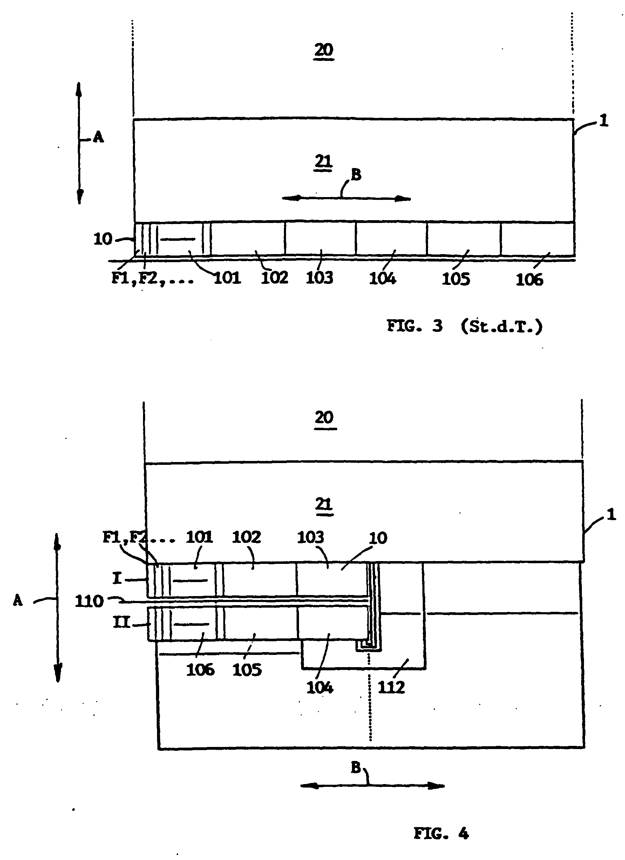

Anhand der beiliegenden Figur 3 wird die bisher übliche Anordnung der Schmelzbrücken auf einem hochintegrierten Speicherchip beschrieben. Die Schmelzbrücken (sogenannte Fuses) F₁, F₂ usw. sind insgesamt räumlich einem Speicherfeldsegment 20 zugeordnet und zusammen mit einer Auswertelogik 21 neben dem Speicherfeldsegment 20, d. h. in Figur 3 unterhalb des Speicherfeldsegments 20 in Lateralrichtung, d. h. in Richtung des Pfeils B, angeordnet. Die gesamte Anordnung der Schmelzbrücken F₁, F₂ usw. bildet eine Bank 10, die ihrerseits in einzelne Schmelzbrückenboxen 101, 102, 103,..., 106 unterteilt ist. Innerhalb einer Box 101-106 können sich beispielsweise zwölf Schmelzbrücken F₁, F₂, ... befinden. Die Auswertelogik 21 hat die Funktion festzustellen, ob eine der Schmelzbrücken F₁, F₂ usw. durchtrennt ist oder nicht.

Das Durchschmelzen einzelner Schmelzbrücken erfolgt mit einem auf den Bereich, in dem sich die Bank 10 der Schmelzbrücken befindet, gerichteten Laserstrahl. Man spricht vom Durchschießen einzelner Schmelzbrücken. Dies bedingt, dass der Bereich der Bank 10 für den Laserstrahl offen sein muss, d.h., dass in dem Bereich der Bank 10 ein Fenster für den Laserstrahl freibleiben muss.

Spezielle Chipkontaktierungsverfahren von Speicherchips auf Waferebene erfordern ein Aufbringen von zusätzlichen Kontaktpads auf der Chipoberfläche mit großen Abständen der Pads untereinander, da die vorhanden Kontaktpads, die nur geringe Abstände untereinander aufweisen, mit diesen speziellen Chipkontaktierungsverfahren nicht direkt kontaktiert werden können. Somit müssen die kleinen Kontaktpads durch Leiterbahnen mit den zusätzlichen Kontaktpads verdrahtet werden.

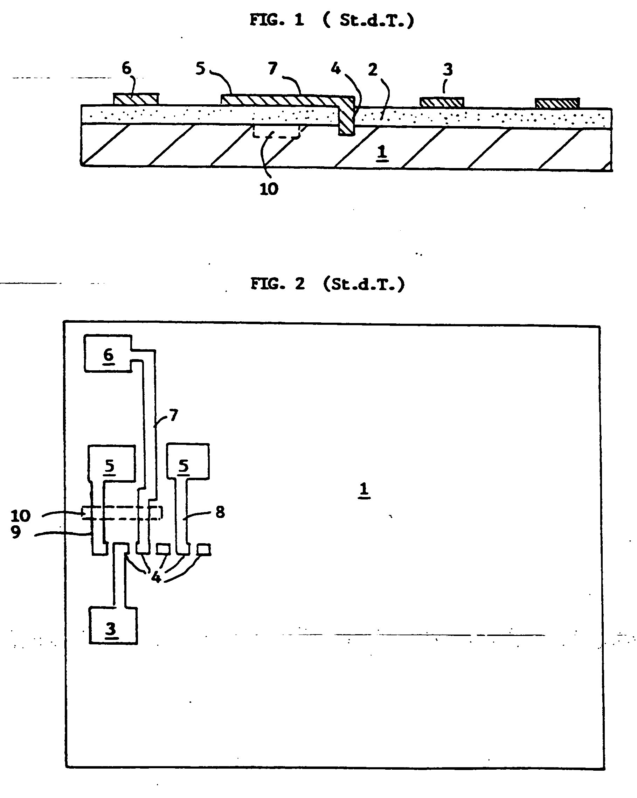

Die beiliegenden Figuren 1 und 2 zeigen jeweils in Form einer schematischen Querschnittsansicht und einer Draufsicht die Anordnung von kleinen Kontaktpads 4 auf einem Chip 1 und von solchen zusätzlichen größeren Kontaktpads 3, 5 und 6, die durch eine Isolationsschicht 2 vom Chip 1 getrennt und durch zusätzliche Leiterbahnen 7, 8, 9 mit den ursprünglichen Kontaktpads 4 verbunden sind.

Soll nun diese Kontaktierung, die die größeren Kontaktpads erforderlich macht, angewandt werden, bevor im Prüfablauf die in einer mit 10 angedeuteten Bank befindlichen Schmelzbrücken auf dem Chip 1 durchtrennt wurden, können durch die zusätzlich erforderlichen Leiterbahnen die darunterliegenden Schmelzbrückenbänke 10 verdeckt werden, so dass ein Durchtrennen aller Schmelzbrücken nicht mehr möglich ist.

In Figur 2 sind beispielhaft zwei Leiterbahnen 7 und 9 gezeigt, die eine Schmelzbrückenbank 10 überdecken. Dies hat unter anderem zur Folge, dass für den Chip 1 defekte Speicherzellen nicht mehr durch redundante ersetzt werden können. Je nach Geometrie der Verdrahtung werden unterschiedlich große Bereiche der Schmelzbrücken verdeckt.

Es ist Aufgabe der Erfindung, eine Schmelzbrückenanordnung in oder auf integrierten Schaltungen, insbesondere hochintegrierten Speicherchips anzugeben, mit der das beschriebene Problem der Überdeckung der Schmelzbrückenbänke durch darüberliegende Leiterbahnen vermieden wird.

Die Aufgabe wird erfindungsgemäß durch eine Aufteilung der Schmelzbrückenbänke in kleiner Einheiten und eine Neuanordnung der genannten Einheiten in der Art gelöst, dass die darüberliegende Verdrahtung die Schmelzbrücken nicht mehr verdeckt, so dass ein Durchtrennen der Schmelzbrücken genau wie ohne das Vorhandensein der zusätzlichen Verdrahtung ermöglicht wird.

Eine Schmelzbrückenanordnung gemäß der Erfindung geht aus dem Anspruch 1 hervor.

Bei einem bevorzugten Ausführungsbeispiel sind die Einheiten so gruppiert, dass die ursprüngliche Breite der Schmelzbrückenbank halbiert ist und dass beide Hälften der Schmelzbrückenbank in einer zur Breitenrichtung senkrechten Richtung nebeneinander liegen.

Dabei sind die Schmelzbrücken an ihren einen Enden, wo sie quer zur Breitenrichtung aneinandergrenzen, mit einer Massebahn verbunden und mit ihren entgegengesetzten anderen Enden jeweils einzeln mit der zugehörigen Auswertelogik verdrahtet.

Die Verdrahtung der Schmelzbrücken mit der Auswertelogik erfolgt z. B. in einer einzigen Ebene des Chips. Diese Verdrahtung kann statt dessen auch in mehreren Verdrahtungsebenen geführt werden, um den Flächenzuwachs, der sich durch diese Verdrahtung ergibt, möglichst klein zu halten.

Idealerweise wird man die Leiterbahnen für die Kontaktierung der zusätzlichen großen Kontaktpads versuchen so zu führen, dass eine Halbierung der Breite der Schmelzbrückenbank bzw. der -bänke ausreicht, um zu gewährleisten, dass alle Schmelzbrücken der Bank oder Bänke zugänglich sind und den zusätzlichen Flächenaufwand durch die neue Verdrahtung der Schmelzbrücken möglichst klein zu halten.

Je nach dem Erfordernis der Leiterbahnführung von den zusätzlichen großen Kontaktpads zu den kleinen Kontaktpads kann aber auch eine weitere Aufteilung der Schmelzbrückenbank notwendig sein, um den Zutritt des Laserstrahls zum Durchtrennen der Schmelzbrücken von oben zu gewährleisten.

Ebenso kann die gesamte Position der Schmelzbrückenbank unter Beibehaltung der Position der Auswertelogik verschoben werden, was aber ein Maximum an zusätzlichem Flächenaufwand nach sich zieht.

Die erfindungsgemäß vorgeschlagene Schmelzbrückenanordnung kann sowohl für Spalten- als auch für Zeilenschmelzbrücken sowie für jegliche andere Art von Schmelzbrücken, z. B. für das Trimmen interner Spannungen, angewandt werden.

Nachstehend wird ein Ausführungsbeispiel der Erfindung anhand der Zeichnung näher beschrieben. Es zeigen:
- Die Figuren 1 und 2: jeweils in schematischem Querschnitt und in einer Draufsicht die bereits beschriebene Anordnung von Kontaktpads und Leiterbahnen über einer Schmelzbrückenbank.
- Figur 3: eine schematische Draufsicht auf einen Abschnitt eines Speicherchips mit einem Speicherfeldsegment.
- Figur 4: eine Draufsicht auf einen Abschnitt eines Speicherchips mit einem Ausführungsbeispiel einer erfindungsgemäßen Schmelzbrückenanordnung.

Die in den Figuren 1 bis 3 gezeigten Anordnungen sind Stand der Technik und bereits oben beschrieben worden.

Gemäß Figur 4 sind die zu einer Bank 10 gehörenden Schmelzbrücken F₁, F₂, ... in Boxen 101, 102, 103, 104, 105, 106 unterteilt und diese in zwei Hälften I und II nebeneinander in Richtung des Pfeils A gruppiert.

Ein Vergleich der Schmelzbrückenanordnung mit der in Figur 3 gezeigten bekannten Schmelzbrückenanordnung zeigt deutlich, dass die erfindungsgemäße Schmelzbrückenanordnung vorteilhafterweise die Hälfte der Breite des Speicherfeldsegments 21 freilässt. Dieser Platz kann dann zur Führung von Leiterbahnen zwischen den zusätzlichen und den normalen Kontaktpads verwendet werden, ohne dass irgend eine der Schmelzbrücken von diesen Leiterbahnen überdeckt würde. Eine Seite der Schmelzbrücken F₁, F₂, ... ist mit einer Masseleitung 110 verbunden und die andere Seite durch Leiterbahnen 112 mit der Auswertelogik 21 verdrahtet. Diese Verdrahtung 112 kann in einer oder mehreren Verdrahtungsebenen geführt werden, um den Flächenzuwachs, der sich durch diese Verdrahtung ergibt, möglichst klein zu halten.

Ein Beispiel für den Flächenzuwachs einer Verdrahtung 112, wenn diese in einer Ebene des Chips geführt ist, ergibt sich wie folgt: 14 µm Höhe der Schmelzbrückenboxen 101, 102, 103,... (in Pfeilrichtung A) + 18 µm für die zusätzliche Verdrahtung 112 bei Führen in einer Metallebene mit einem Zellenfeldpitch von 0,5 µm über die gesamte Chiplänge x 2, da zwei Reihen I und II von Schmelzbrückenbankreihen im Spine vorhanden sind; das ergibt 0,5 mm² und entspricht 1,6% der Gesamtchipfläche eines beispielhaft angenommenen 64 M Speicherchips.

Selbstverständlich ist die in Figur 4 gezeigte Ausführung bei der die Schmelzbrückenboxen in zwei Hälften eingeteilt und in zwei parallelen Reihen I und II in Richtung des Pfeils A nebeneinander angeordnet sind, lediglich beispielhaft.

Idealerweise wird man die zusätzlichen Leiterbahnen für die Kontaktierung der zusätzlichen großen Kontaktpads versuchen so zu führen, dass die in Figur 4 gezeigte Halbierung der Breite der Schmelzbrückenbank 10 ausreicht, um zu gewährleisten, dass alle Schmelzbrücken F₁, F₂,...der Bank 10 für den Laserstrahl zugänglich sind. Selbstverständlich ist auch eine weitere Aufteilung der Bank 10 vorstellbar, um den Zugang von oben zu gewährleisten.

Ebenso kann die gesamte Position der Bank 10 unter Beibehaltung der Position der Auswertelogik 21 verschoben werden. Dies kann aber einen zu großen Flächenaufwand für die Verdrahtung nach sich ziehen.

## Patentansprüche

1. Schmelzbrückenanordnung in oder auf integrierten Schaltungen, insbesondere hochintegrierten Speicherchips, bei denen jeweils eine Bank (10) von Schmelzbrücken (F₁, F₂, ...) zusammen mit einer mit den Schmelzbrücken (F₁, F₂, ...) elektrisch verbundenen Auswertelogik (21), die feststellt, ob eine oder mehrere der Schmelzbrücken (F₁, F₂, ...) durchtrennt ist, neben und in Zuordnung zu einem Speicherfeldsegment (20) in einer Lateralrichtung (B) angeordnet ist, wobei eine oder mehrere in kleinere Einheiten (101, ... 106) aufgeteilte Bänke (10) der Schmelzbrücken (F₁, F₂, ...) unter Einschränkung der Breite(n) der Bank (10) bzw. Bänke so gruppiert sind, **dass** wenigstens ein Teil der Schmelzbrücken (F₁, F₂, ...) quer zur Lateralrichtung (B) der Bank (10) nebeneinander liegt,
**dadurch gekennzeichnet, dass**
(a) zumindest eine mit der Auswertelogik (21) verbundene, über den Schmelzbrücken (F₁, F₂, ...) liegende Leiterbahn (112) vorhanden ist;
(b) die Bänke (10) derart aufgeteilt sind, dass ein Teil von der Breite der Auswertelogik (21) frei von Schmelzbrücken gelassen ist; und
(c) die Leiterbahn (112) zur Auswertelogik geführt ist, ohne eine der Schmelzbrücken (F₁, F₂, ...) mit dieser Leiterbahn (112) zu überdecken.

2. Schmelzbrückenanordnung nach Anspruch 1,
**dadurch gekennzeichnet, dass**
die Bänke (10) senkrecht zu deren Breitenrichtung (B) nebeneinander liegen.

3. Schmelzbrückenanordnung nach Anspruch 1 oder 2,
**dadurch gekennzeichnet, dass**
die Schmelzbrücken (F₁, F₂...) an ihrem einen Ende, an dem sie quer zur Breitenrichtung (B) aneinandergrenzen, mit einer Massebahn (110) verbunden sind und mit ihren entgegengesetzten anderen Enden jeweils einzeln mit der zugehörigen Auswertelogik (21) verdrahtet sind.

4. Schmelzbrückenanordnung nach Anspruch 3,
**dadurch gekennzeichnet, dass**
die Verdrahtung (112) der Schmelzbrücken (F₁, F₂, ...) mit der Auswertelogik (21) in einer oder mehreren Metallisierungsebenen eines Chips (1) geführt ist.

## Claims

1. Fusible link arrangement in or on integrated circuits, in particular highly integrated memory chips, in which in each case one bank (10) of fusible links (F₁, F₂, ...), together with an evaluation logic unit (21) which is electrically connected to the fusible links (F₁, F₂, ...) and determines whether one or more of the fusible links (F₁, F₂, ...) is severed, is arranged beside and in association with a memory field segment (20) in a lateral direction (B), one or more banks (10) of the fusible links (F₁, F₂, ...), divided up into smaller units (101, ... 106) while restricting the width(s) of the bank (10) or banks, being grouped such that at least some of the fusible links (F₁, F₂, ...) are located beside one another transversely with respect to the lateral direction (B) of the bank (10),
**characterized in that**
(a) at least one conductor track (112) connected to the evaluation logic unit (21) and located above the fusible links (F₁, F₂, ...) is present;
(b) the banks (10) are divided up in such a way that some of the width of the evaluation logic unit (21) is left free of fusible links; and
(c) the conductor track (112) is routed to the evaluation logic unit without covering one of the fusible links (F₁, F₂, ...) with this conductor track (112).

2. Fusible link arrangement according to Claim 1, **characterized in that** the banks (10) are located beside one another at right angles to the width direction (B) thereof.

3. Fusible link arrangement according to Claim 1 or 2, **characterized in that** at their one end, at which they adjoin one another transversely with respect to the width direction (B), the fusible links (F₁, F₂, ...) are connected to an earth track (110) and, at their opposite, other ends, are in each case wired individually to the associated evaluation logic unit (21).

4. Fusible link arrangement according to Claim 3, **characterized in that** the wiring (112) of the fusible links (F₁, F₂, ...) to the evaluation logic unit (21) is routed in one or more metallization planes of the chip (1).

## Revendications

1. Dispositif à ponts fusibles dans ou sur des circuits intégrés, notamment des puces de mémoire très intégrées, dans lesquelles respectivement un banc (10) de ponts (F₁, F₂...) fusibles est disposé ensemble avec une logique (21) d'évaluation, qui est reliée électriquement aux ponts (F₁, F₂...) fusibles et, qui constate si un ou plusieurs des ponts (F₁, F₂...) fusibles est coupé, à côté et en association avec un segment (20) de champ de mémoire dans une direction B latérale, un ou plusieurs des bancs (12), répartis en des unités (101,... 106) plus petites des ponts (F₁, F₂...) fusibles, étant regroupés avec limitation de la largeur ou des largeurs du banc (10) ou des bancs de sorte qu'au moins une partie des ponts (F₁, F₂...) fusibles soient côte à côte transversalement à la direction latérale (B) du banc (10),
**caractérisé en ce que**,
(a) il y a au moins une piste (112) conductrice reliée à la logique (21) d'exploitation et se trouvant sur les ponts (F₁, F₂...) fusibles.
(b) Les bancs (10) sont répartis de façon à ce qu'une partie de la largeur de la logique (21) d'exploitation soit laissée libre de pont fusible ; et
(c) la piste (112) conductrice va à la logique d'exploitation sans que l'un des ponts (F₁, F₂...) fusibles soit recouvert de cette piste (112) conductrice.

2. Dispositif à ponts fusibles suivant la revendication 1, **caractérisé en ce que** les bancs (10) sont disposés côte à côte perpendiculairement à leur direction (B) en largeur.

3. Dispositif à ponts fusibles suivant la revendication 1 ou 2, **caractérisé en ce que** les ponts (F₁, F₂...) fusibles sont reliés, à l'une de leur extrémité où ils sont voisins transversalement à la direction (B) en largeur, à une piste (110) à la masse et sont câblés par leur autre extrémité opposée respectivement et individuellement à la logique (21) d'exploitation associée.

4. Dispositif à ponts fusibles suivant la revendication 3, **caractérisé en ce que** le câblage (112) des ponts (F₁, F₂...) fusibles à la logique (21) d'exploitation passe dans un plan ou dans plusieurs plans de métallisation d'une puce (1).
